# EUROPEAN PATENT APPLICATION

(11) **EP 4 556 604 A1**
(43) Date of publication of application: **21.05.2025**
(21) Application number: 23386118.6
(22) Date of filing: 17.11.2023
(51) Int. Cl.: C30B 29/12

(54) **COMPLEX QUATERNARY PEROVSKITES BASED ON NOBLE METALS**

(71) Applicant: Special Account for Research Funds of University of Crete (SARF UoC), 74150 Rethimnon (GR)
(72) Inventor: Stoumpos, Konstantinos, 70013 Crete (GR); Michailidis, Barakat Alaelntin, 70013 Crete (GR)

(57) **Abstract**

The present invention relates to halide perovskite crystalline compounds of the general formula AaMbM'cXd and mixtures thereof, to methods for producing the same, its characterization and their use in optoelectronics devices. More particularly, it relates to new halide perovskite crystalline compounds comprising at least one transition metal selected from the tenth group of the periodic table of the chemical elements and a second transition metal may be selected from the eleventh group of the periodic table of the chemical elements.

## Description

### Technical Field

The present invention relates to halide perovskite crystalline compounds of the general formula AaMbM'cXd and mixtures thereof, to methods for producing the same, its characterization and their use in optoelectronics devices.

### Background of the invention

Recently, halide perovskite crystalline compounds have been characterized as promising candidates for optoelectronic applications due to their outstanding optoelectronic properties and facile methods for producing thereof, halide perovskites (HPs) have been identified as one of the most promising materials in photovoltaic and light-emitting devices.

In nature, perovskite crystalline compounds are primarily found as oxides, with the majority being silicates but they also exist as fluorides, chlorides, hydroxides, arsenides, and intermetallic compounds. Halide perovskite crystalline compounds which are found to be useful due to their optimum optoelectronic properties, are compounds which comprise halides. A halide ion is a halogen atom bearing a negative charge.

Known halide perovskite crystalline compounds are found to suffer from instability.

Halide perovskite crystalline compounds being important compounds in optoelectronics devices, there still appears to be a need for new halide perovskite crystalline compounds having further improved physical and/or chemical properties. Hence it was thought worthwhile by the inventors of the present application to explore novel halide perovskite compounds, which may further improve the characteristics of known halide perovskites and their applications thereof. Inventors of the present application here in this application report halide perovskite crystalline compounds of the general formula AaMbM'cXd, wherein the transition metals are selected from the tenth and eleventh group of the periodic table and mixtures thereof. Halide perovskite crystalline compounds of the general formula AaMbM'cXd of the invention are sufficiently stable. These stable halide perovskite crystalline compounds offer various advantages in terms of storage and shelf life of the applications used therein.

### Brief description of drawings

FIG.1. Crystal structure of Cs5CuPd2Br10 obtained by SC-XRD measurement along (a) the corners of the unit cell lattice, (b) the c-axis and (c) the isolated octahedra-tetrahedra that form "1D chains".
FIG.2. Theoretical and experimental XRD pattern comparison of Cs5CuPd2Cl10 and Cs5AgPd2Br10.
FIG.3. SEM images of (a) Cs5AgPd2Br10 and (b) Cs5CuPd2Cl10.
FIG.4. Crystal structure of Cs2AgPd2Cl5 obtained by SC-XRD measurement along (a) the corners of the unit cell lattice, (b) the a-axis and (c) c-axis.
FIG.5. Theoretical and experimental XRD pattern comparison of Cs2AgPdClS.
FIG.6. SEM images of Cs2AgPd2Cl5.
FIG.7. The crystal structure of Cs4Au2PdnI12 obtained from Single Crystal XRD (a) and the "gaps" along the diagonals of the cell (b).
FIG.8. The pattern of the central cations along the b & c crystallographic axis of the of the Cs4Au2PdoI12.
FIG.9. Powder XRD measurements in comparison to the theoretical pattern measurements obtained from SCXRD data.
FIG.10. SEM measurements for (a) Cs4Au2PdoI12, (b) Cs4Au2Pd□Br12 & (c) Cs4Au2Pd□Cl12.
FIG.11. Powder XRD measurements of Rb4Au2Pd□X12 (X = Cl, Br, I) in comparison to the theoretical pattern measurements obtained from SC-XRD data.
FIG.12. Crystal structure of Cs4Au1.33Pt1.67I12 obtained by SC-XRD measurement (a) and vied along the corners of the unit cell lattice.
FIG. 13. Theoretical and experimental XRD pattern comparison of Cs4Au1.33Pt1.67I12 with the reflections made by the impurities of Cs2PtI6 marked by (*.)
FIG.14. SEM images of Cs4Au1.33Pt1.67I12.
FIG.15. The pattern of (CH3NH3)2AuPd0.5I6.
FIG.16. Theoretical and experimental XRD pattern comparison of (CH3NH3)2AuPd0.5I6.
FIG.17. SEM images of (CH3NH3)2AuPd0.5I6 (a) material (b) magnified.

### Summary of the invention

It is therefore an object of the present invention to provide new halide perovskite crystalline compounds without the foregoing disadvantages inherent in the known halide perovskite crystalline compounds. The new halide perovskite crystalline compounds of the invention comprise at least one transition metal selected from the tenth group of the periodic table of the chemical elements and a second transition metal may be selected from the eleventh group of the periodic table of the chemical elements.

In one aspect, the present invention provides halide perovskite crystalline compound of the general formula AaMbM'cXd and mixtures thereof, containing of:
i) a monovalent cation A selected from Li, Na, K, Rb, Cs or an organic monovalent cation and combinations thereof,
ii) a halogen X selected from F, Cl, Br, I and combinations thereof,
iii) at least one transition metal M selected from Cu, Ag, Au and combinations thereof, and
iv) a second transition metal M' selected from Ni, Pd, Pt and combinations thereof,
wherein a and d, are integer numbers and the molecular ratio b:c of two transition metals is 1:2 to 2:1.

In another aspect, the present invention provides halide perovskite crystalline compound of the formula A2MM'X5, or A2MM'0.5X6 or A4M2M'X12 or A4M1.5M'1.5X12 or A5MM'2X10 or wherein the monovalent cation A is selected from Li, Na, K, Rb, Cs or an organic monovalent cation and combinations thereof, the halogen X is selected from F, Cl, Br, I and combinations thereof, and the at least one transition metal M selected from Cu, Ag, Au and combinations thereof, and a second transition metal M' selected from Ni, Pd, Pt and combinations thereof. Preferably, the organic monovalent cation is selected from methylammonium (CH3NH3+) and formamidinium (HC(NH2)2.

In a further aspect, the present invention provides a method for preparing a halide perovskite crystalline compound, comprising:
i) adding elemental M or a compound comprising a transition metal M, wherein M is selected from Cu, Ag, Au and combinations thereof, to elemental M' or a compound comprising transition metal M', wherein M' selected from Ni, Pd, Pt and combinations thereof, into concentrated a hydrohalic acid (HX), wherein X is a halide selected from Cl, Br and I,
ii) heating the mixture of step i) to boil until clear solution is obtained,
iii) adding a monovalent cation A salt, wherein A is selected from Li, Na, K, Rb, Cs or an organic monovalent cation and combinations thereof,
iv) cooling to ambient temperature (at about 25°C).

Optionally, when elemental Au is used in step i) stoichiometric quantity of elemental iodine and/or bromine is added. The further addition affords intensely colored clear solutions containing AuIII and facilitates solubilization.

The disclosed method presents a simpler alternative path of synthesis compared to known solid-state methods.

Within the scope of this invention the term "compound" is a chemical substance containing atoms from more than one chemical element held together by chemical bonds.

Within the scope of this invention the term "elemental" is a chemical substance of one type of atom.

The smallest repeating unit of a crystal lattice is the unit cell.

It's within the scope of this invention is to provide the use of a halide perovskite crystalline compounds of the invention and mixtures thereof for the manufacturing of optoelectronic device components by deposition on a substrate or single crystal growing.

Furthermore, methods of preparing and using the halide perovskite crystalline compounds of the present invention are also described, for solar cells.

"Periodic table of the chemical elements" is well known, arranges the chemical elements into rows ("periods") and columns ("groups").

The term "halide" represents a halide ion is a halogen atom bearing a negative charge. For the scope of this invention, the halide anions commonly used are fluoride (F-), chloride (Cl-), bromide (Br-) and iodide (I-).

The term "perovskite" represents, within this invention, the structure of the compounds.

The synthesis of novel halide perovskites of the invention and their characterization of their structural and physico-chemical properties, with material properties that give emphasis on energy related applications, such as photovoltaics.

The disclosure of this patent specification is not intended to be limited to the specific terminology but includes all technical equivalents that have the same function, operate in a similar manner, and achieve similar results.

### Detailed description of the invention

Halide perovskite crystalline compounds have been developed and are reported herein.

It has been determined that stable halide perovskite crystalline compounds are prepared, within the scope of this invention.

A halide perovskite crystalline compound of the general formula AaMbM'cXd and mixtures thereof, containing of
i) a monovalent cation A selected from Li, Na, K, Rb, Cs or an organic monovalent cation and combinations thereof,
ii) a halogen X selected from F, Cl, Br, I and combinations thereof,
iii) at least one transition metal M selected from Cu, Ag, Au and combinations thereof, and
iv) a second transition metal M' selected from Ni, Pd, Pt and combinations thereof,
wherein a and d, are integer numbers and the molecular ratio b:c of two transition metals is 1:2 to 2:1.

The halide perovskite crystalline compound of the invention contains at least one transition metal selected from the tenth group of the periodic table of the chemical elements and a second transition metal selected from the eleventh group of the periodic table of the chemical elements.

Preferably, the organic monovalent cation is selected from methylammonium (CH3NH3+) and formamidinium (HC(NH2)2.

Within the scope of this invention, a halide perovskite crystalline compound of the general formula AaMbM'cXd wherein the molecular ratio of the halogen to monovalent cation d:a is within the range of 3.0 -1.0. Preferably, wherein when a=2 then d=5 or 6, when a=4 then d=12 and when a=5 then d=10.

Furthermore, within the scope of this invention, a halide perovskite crystalline compound, wherein each compound of the general formula AaMbM' cXd thereof is selected from the group consisting of A2MbM'cX5, A2MbM'cX6, A4MbM'cX12, A4MbM'cX12, A5MbM'cX10, wherein the molecular ratio b:c of two transition metals is 1:2 to 2:1. Preferably, b and c are selected from the range 0.1-3.0. Both b and c may be integer or decimal numbers. More preferably, b is any number from 1 to 2 and c is any number from 0.5 to 2.

In one embodiment, a halide perovskite crystalline compound represented by the formula A2MM'X5 is disclosed. A halide perovskite crystalline compound of Cs2AgPdCl5, is presented.

In another embodiment, a halide perovskite crystalline compound represented by the formula A2MM'0.5X6 is disclosed. A halide perovskite crystalline compound of (CH3NH3)2AuPd0.5I6, is presented.

In another embodiment, a halide perovskite crystalline compound represented by the formula A4M2M'X12 is disclosed. A halide perovskite crystalline compound of Cs4Au2Pd□Cl12, Cs4Au2PdBr12, Cs4Au2PdI12 and Rb4Au2PdI12, is presented.

In another embodiment, a halide perovskite crystalline compound represented by the formula A4M1.5M'1.5X12 is disclosed. A halide perovskite crystalline compound of Cs4Au1.33Pt1.67I12, is presented.

In another embodiment, a halide perovskite crystalline compound represented by the formula A5MM'2X10 is disclosed. A halide perovskite crystalline compound of Cs5CuPd2Cl10, Cs5AgPd2Br10 and Cs5CuPd2Br10, is presented.

These exemplary embodiments of the present disclosure should not be interpreted to limit the scope thereof.

A halide perovskite crystalline compound, wherein each compound of the general formula AaMbM'cXd thereof is selected from the group consisting of : Cs2AgPdCl5, (CH3NH3)2AuPd0.5I6, Cs4Au2PdCl12, Cs4Au2PdBr12, Cs4Au2PdI12, Rb4Au2PdI12, Cs4Au1.33Pt1.67I12, Cs5CuPd2Cl10, Cs5AgPd2Br10 and Cs5CuPd2Br10.

The present invention provides a method for preparing a halide perovskite crystalline compound, comprising:
i) adding elemental M or a compound comprising a transition metal M, wherein M is selected from Cu, Ag, Au and combinations thereof, to elemental M' or a compound comprising transition metal M', wherein M' selected from Ni, Pd, Pt and combinations thereof, into concentrated a hydrohalic acid (HX), wherein X is a halide selected from Cl, Br and I,
ii) heating the mixture of step i) to boil until clear solution is obtained,
iii) adding a monovalent cation A salt, wherein A is selected from Li, Na, K, Rb, Cs or an organic monovalent cation and combinations thereof,
iv) cooling to ambient temperature.

Preferably, cooling in step iv) is cooling to ambient temperature at about 25°C.

In one embodiment, adding elemental or a compound comprising a transition metal in step i) comprises adding both elemental or compounds with each transition metal in pure form followed by adding concentrated a hydrohalic acid (HX), wherein X is a halide selected from Cl, Br and I. In another embodiment, adding elemental or a compound comprising a transition metal in step i) comprises combine a mixture of each elemental or compound comprising a transition metal in concentrated a hydrohalic acid (HX), wherein X is a halide selected from Cl, Br and I. Optionally, when elemental Au is used in step i) stoichiometric quantity of elemental iodine and/or bromine is added.

Preferably, the mixture of step i) is covered with a surface. More preferably, the surface is a silicone surface.

A halide perovskite crystalline compound according to some embodiments are represented by the formula A2MM'X5, or A2MM'0.5X6 or A4M2M'X12 or A4M1.5M'1.5X12 or A5MM'2X10, where: a monovalent cation A is selected from Li, Na, K, Rb, Cs or an organic monovalent cation and combinations thereof, a halogen X is selected from F, Cl, Br, I and combinations thereof, at least one transition metal M is selected from Cu, Ag, Au and combinations thereof, and a second transition metal M' is selected from Ni, Pd, Pt and combinations thereof. Halide perovskite compounds according to various embodiments are discussed in greater detail below. Preferably, the organic monovalent cation is selected from methylammonium (CH3NH3+) and formamidinium (HC(NH2)2.

Within the scope of this invention the halide perovskite crystalline compounds of the invention are in the form of powder, single crystal or thin film.

The halide perovskite crystalline compounds in accordance with some embodiments of the present invention may also advantageously be used in any optoelectronic device, with some examples including, but not limited to: solar sells, telecommunication laser, blue laser, optical fiber, LED traffic light and, photo diodes. Such devices may include halide perovskite crystalline compounds as interfacial layers. The halide perovskite crystalline compounds of the invention may be incorporated into various of one or more aspects of optoelectronic or other device. Preferably, halide perovskite crystalline compounds of the invention are manufactured by deposition on a substrate or single crystal growing when being used in optoelectronic or other device.

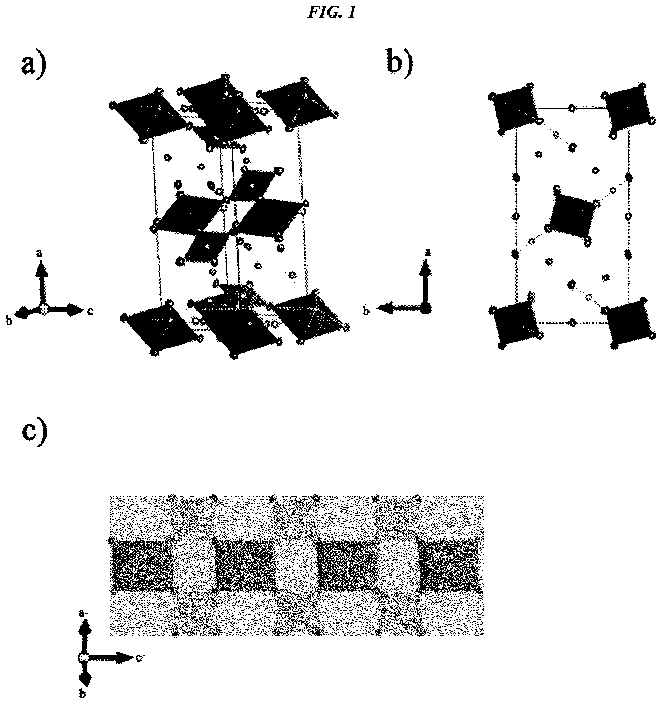

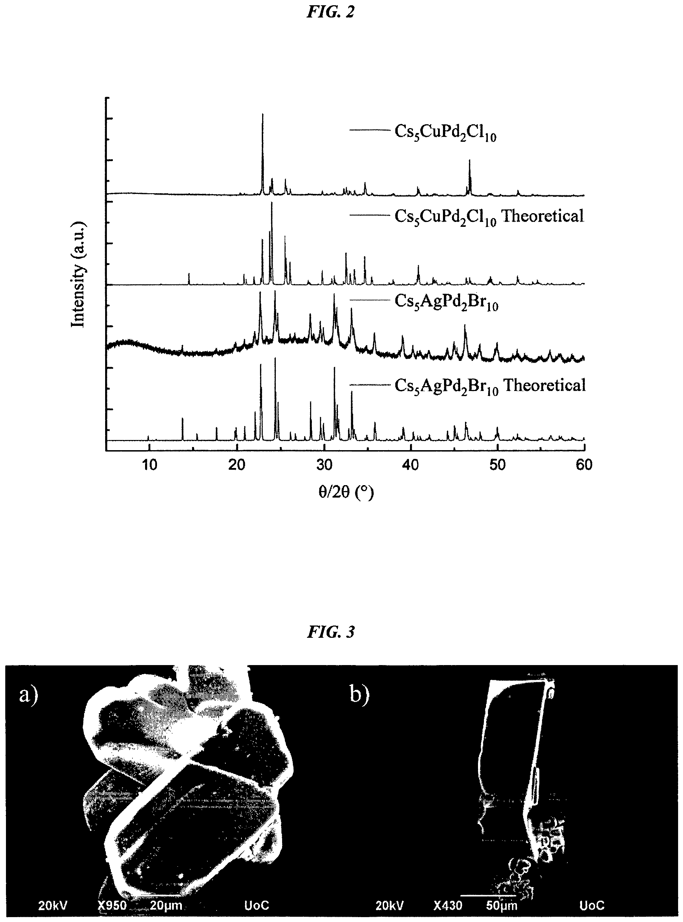

In one embodiment of the invention the metal halide perovskite of formula A5MM'2X10 structure consists of a linear arrangement of octahedra - tetragonal units. The one dimensional nature of the structure could allow for potential use in nanoelectronics and photonics. The Cs5MPd2X10 structures crystalize in the Cs5MPd2X10 (M = Cu, Ag; X = Cl, Br) structures crystallize in the centrosymmetric orthorhombic Pbam space group adopting a crystal structure that resembles features of a linear double perovskite, as shown in FIG. 1 for Cs5CuPd2Br10. The structure consists of [PdX4]2-squares and [MX2]- rods which are typical coordination modes for the d8 and d10 electronic configurations of the corresponding transition metal. The two polygons are connected via weak bonding interactions (Ag-Br 3.19 Å and Cu-Cl 3.12 Å) where four [PdX4]2- squares are connected side-on with the [MX2]- rod across its equatorial plane thus forming a heavily deformed (compressed) [MX6]2- octahedron. Each [PdX4]2-square bridges across two [MX2]- forming an infinite for example [Pd2CuCl10]5-heterometallic chain along the crystallographic c-axis. The chains are separated from one another via five Cs atoms that interpose between them in addition of serving as charge-balancing ions that maintain neutrality in the structure. The structure is comprised of corner sharing CuCl6 or AgBr6 octahedra connected to two PdCl4 or PdBr4 tetragonal planes. The powder XRD pattern is in good agreement with the data obtained from single crystal diffraction of Cs5CuPd2Cl10 and Cs5AgPd2Br10, as seen in FIG. 2. Although no biproducts can be identified by the powder XRD measurement in FIG. 2 in the case of CsSAgPd2Br10 a second absorption energy is observed at approximately 2.45eV. We determined that the binding energies of the compounds gathered by high resolution In the range of Pd(II) between 355-325eV a characteristic shift of the binding energy can be observed as we move from PdCl2 to PdBr2. While the existence of Cu(I) and Ag(I) can be seen in the ranges of 960-920eV and 380-360eV. Optically, the band gap of the compounds Cs5CuPd2Cl10 and Cs5AgPd2Br10 was measured using UV-vis-NIR spectroscopy and is measured to be approximately 1.95eV for Cs5AgPd2Br10 and 2.15eV for Cs5CuPd2Cl10. The band gap in both cases appears to be indirect in nature. The synthesis of Cs5MPd2X10 (M = Cu, Ag; X = Cl, Br) may proceed via a one-step reaction using a stoichiometric mixture of Cs2CO3, MX and α-PdCl2 in the corresponding hydrohalic acid according to a balanced chemical equation. The reaction proceeds in nearly quantitative yield in the case of bromides but when HCl is employed, the poor solubility of the ternary compound Cs2PdCl4 which immediately crushes out of the solution upon addition of the Cs salt, required the use of reduced amounts of α-PdCl2 (typically one half of the stoichiometric amount) specifically to prevent the co-precipitation of the reaction byproduct. The morphology of the compounds resembles orthorhombic crystals that macroscopically resemble small needles FIG.3.

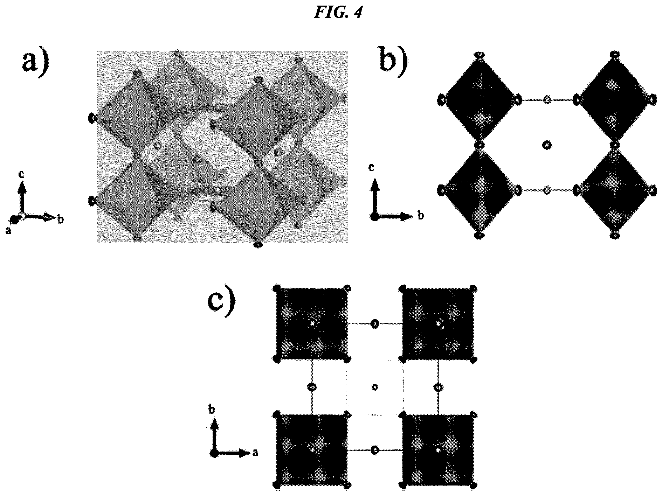

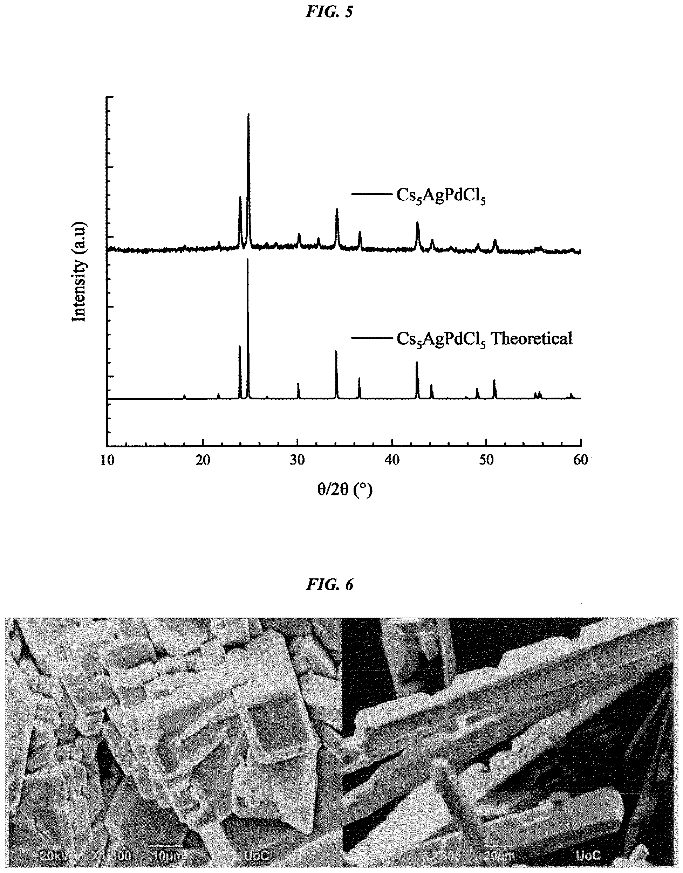

In another embodiment of the invention the metal halide perovskite Cs2AgPdCl5 of formula A2MM'X5 structure wherein the crystal structure FIG. 4 resembles quite closely that of a Perovskite with a difference, that two halves of halide ions are missing, due to the preferential coordination of Pd to square planar geometry. The silver atoms also adopt their typical coordination geometry forming linear [AgCl2]- anions. Coordination preference is the only distinctive characteristic between the two metal centers since otherwise X-ray diffraction is unable to distinguish between metal ions with such similar atomic numbers. The squares and the rods connect side-on across the metal centers via weak bonding interactions forming infinite two-dimensional (2D) sheets. The sheets extend to three dimensions via sharing of the chloride ions of the [AgCl2]- rods. The structure resembles a "true" double perovskite. Cs2AgPdCl5 crystalizes in the tetragonal P4/mmm space group. The powder XRD pattern is in good agreement with the data obtained from single crystal diffraction as seen in FIG. 5. Optically, the band gap of the compounds was measured using UV-vis-NIR spectroscopy and is measured to be approximately 1.5eV. The compound Cs2AgPdCl5 may be synthesized by a stoichiometric reaction of the constituent elements in aqueous hydrochloric acid according to a non-stoichiometric equation. The synthetic protocol for this reaction requires the use of relatively dilute solutions since both Ag (as AgCl) and Pd (as Cs2PdCl4) have relatively low solubility in concentrated aqueous HCl. Moreover, the Ag/Pd ratio needs to be readjusted to an excess (-two-fold) of Pd to avoid the precipitation of AgCl. Switching to other congeners by changing the hydrohalic acid did not yield any analogous product, since there is a strong tendency for Pd to oxidize in the presence of Ag to afford a vacancy-ordered double perovskites Cs2PdX6 (X = Br, I), without any strong evidence of other quaternary products forming as side products. The crystal morphology for Cs2AgPdCl5 FIG. 6 is elongated tetragonal needles, truncates across the vertices.

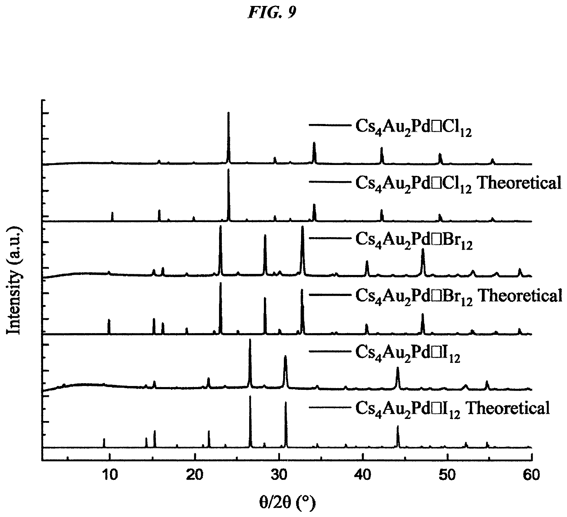

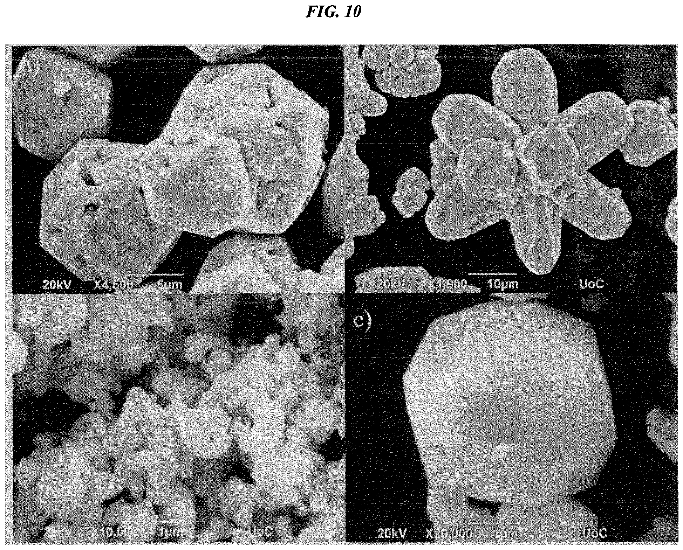

In another embodiment of the invention the metal halide perovskite Cs4Au2PdaX12 of formula A4M2M'X12 structure, are euhedral crystals with deltoidal eicositetrahedral geometry a polyhedron that belongs to the class 11 Catalan solids. The crystal shape can be thought to be formed from regular octahedron (a Platonic solid) by capping all eight trigonal facets. Despite similarities with the typical rhombic dodecahedral (Catalan solid) morphology common in group 14 metal halide perovskites, the shape originates from a different Platonic solid, by fusing together square pyramids capped on the six facets of a cube as shown in SEM FIG. 10. The theoretical and experimental XRD pattern of the crystal family are in good compliance FIG.9.

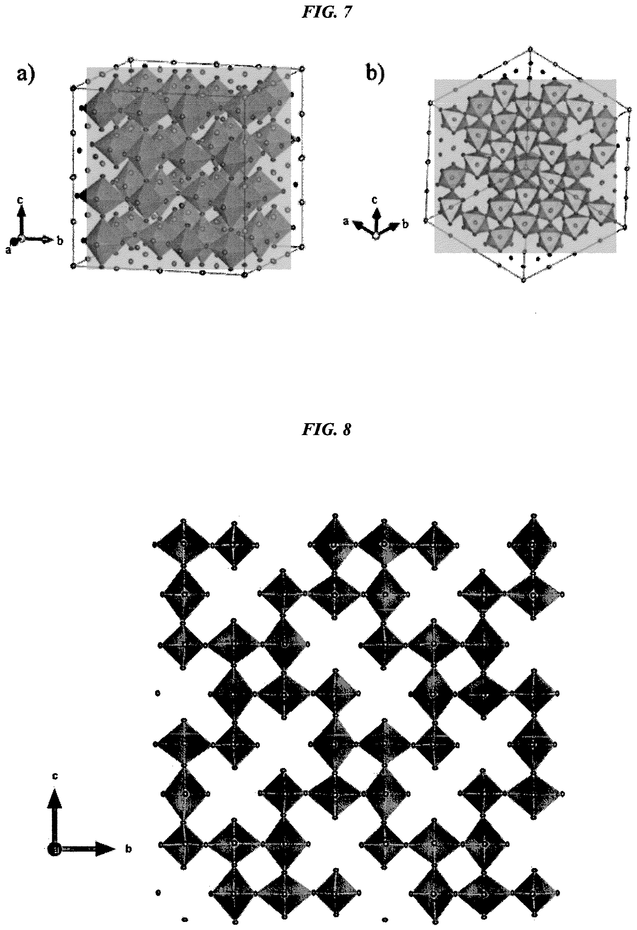

The Cs4Au2PdaX12 crystal family is determined to be a 4x4x4 perovskite super cell that crystallizes in the cubic Ia-3d (No. 230) space group. The structure consists of a single metal site shared between Pd and Au in a 1:2 ratio in the oxidation states AuIII and PdII, as determined by refinement of the site occupancy. The crystal structure as shown in FIG.7 a), closely resembles the structure of a perovskite with corner-connected octahedra extending in three directions. Unlike a regular perovskite, there are four different possible positions available for metal cations. The unit cell forms star-shaped channels with Cs ions being exclusively the filling the voids as shown in FIG. 7 b).

The origins of this unique structural configuration lie in the special configuration of square planar geometry of the constituent PdIIX4 and AuIIIX4 metals which is typical for their respective oxidation states. The squares are aligned in ABCD· · ·ABCD stacking pattern as the one shown in FIG. 8. The initial square lies flat on the ac-plane, then flipped by 90° to lie on the ab-plane, then flipped again to lie on the bc-plane, followed by a vacancy (□), before the pattern repeats itself. The metal cations form bonds in pairs of 3 non connected tetragonal-planar formations. These formations orient in a pattern in the a-b axis, followed by the a-c axis and then the b-c axis. Examining a "slice" across the unit cell of Cs4Au2PdoI12 (on the be plane, FIG. 8.) a checkered pattern can be observed, where double dagger (‡) shaped vacancies interrupt the square corner-connectivity. When these slices are overlayed on top of one another (also in ABCD· · ·ABCD sequence) the vacancies are "masked", but viewed when lay one on top of the other, thus generating the channels shown in FIG. 7.

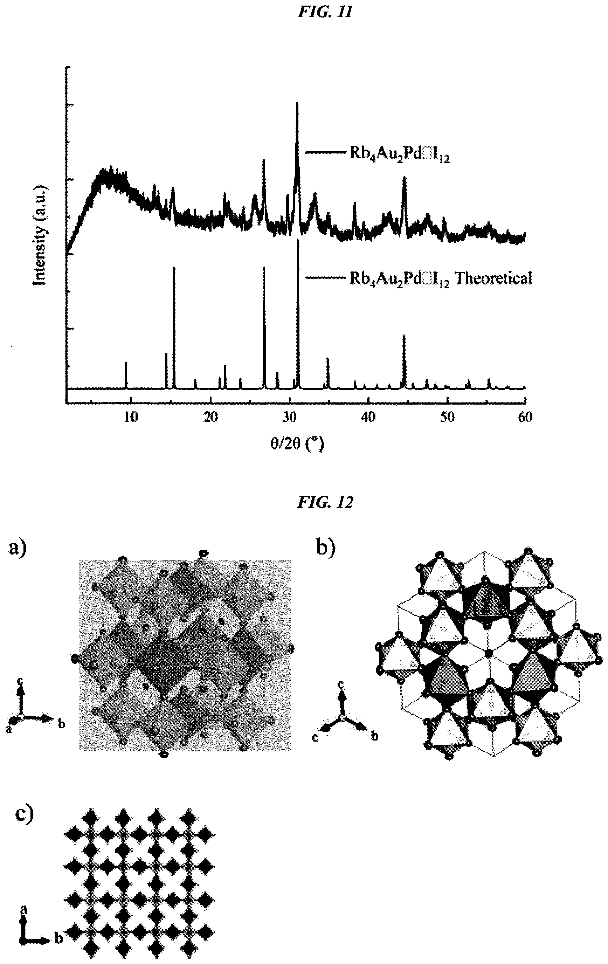

The synthesis of the compounds Cs4Au2PdoX12 may proceed in almost stoichiometric fashion producing nearly quantitative yields. The isolated compounds have a very-high purity and are stable in water but tend to oxidize in concentrated hydrohalic acids in the presence of air to afford PdIV products. The synthesis can involve a 2-step process, where Au and α-PdCl2 were dissolved separately in different beakers containing the corresponding hydrohalic acid. Elemental gold can be easily dissolved in the acids by the addition of elemental iodine and bromine to afford intensely colored clear solutions containing AuIII. In the case of X = Cl AuIII was used directly as AuCl3·xH2O. Mixing together the AuIII and PdII solutions does not produce any effect. Furthermore, A site cation with Rb with the same synthetic process has yielded similar results. Powder XRD measurements of Rb4Au2Pd□X12 (X = Cl, Br, I) in comparison to the theoretical pattern measurements obtained from SC-XRD data are shown in FIG 11.

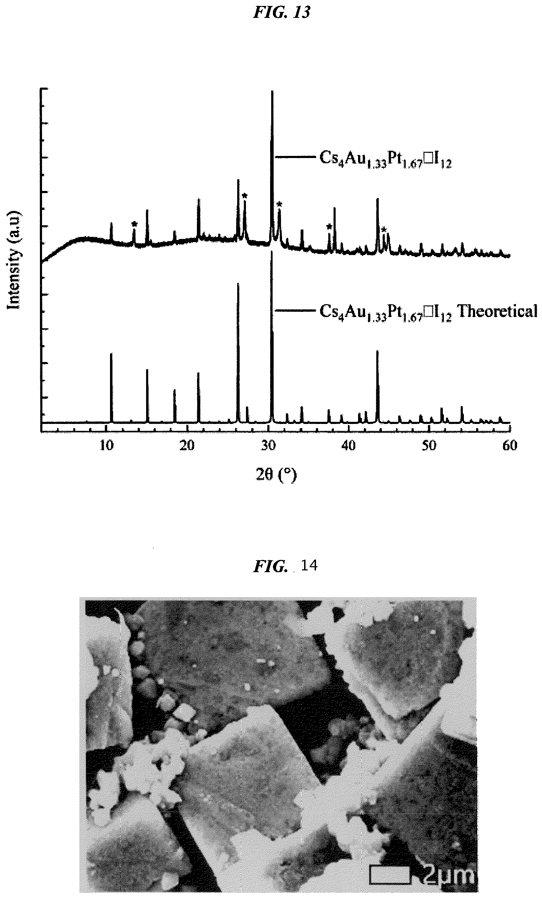

In another embodiment of the invention the metal halide perovskite Cs4Au1.33Pt1.67I12 of formula A4M1.5M'1.5X12 structure was prepared. The Cs4Au1.33Pt1.67I12 crystalizes in the cubic Pm-3m space group. The incorporation of platinum substituting for Pd in the structure leads to a different crystal structure which, however, bears some similarities with the Pd Cs4Au2PdoI12 structure (vide supra). Cs4Au1.33Pt1.67□I12 adopts an ordered version of the quadrupled vacancy-ordered halide perovskites FIG. 12, where instead of the two metal to occuping the same atomic positions, they instead order to occupy discrete position in the lattice, possibly due to the large size mismatch of AuI and PtI. Unlike typical vacancy ordered perovskites which crystallize in the Fm-3m space group, Cs4Au1.33Pt1.67□I12 adopts a primitive crystal system, since in addition to the metal ordering, an ordered vacancy is also present. Despite the chemical formula being similar, the unit cell dimensions of the crystals are half length in comparison with Pd analogue which also has a different lattice centering. Besides the difference in the size of the metals, the two different oxidation states also have a strong impact on the coordination preference. Thus, instead of the metal ions sitting in the barycenter of planar squares, AuI adopts its typical for a 5d10 system [AuI2]- rod like shape whereas PtIV adopts a regular octahedral coordination. The ordered topology of rods and octahedra, naturally produces voids in the lattice which occupy the corner and center positions of the primitive lattice. As in the case of Pd-based structure, the arrangements of the vacancies generate channels, which can be clearly seen in FIG. 12. If one "slices" across the unit cells of Cs4Au1.33Pt1.67□I12 the patterns of this class of vacancy ordered perovskites can evolve, depending on whether the connectivity occurs via rods and octahedra (Au-Pt). The powder XRD pattern is in good agreement with the data obtained from single crystal diffraction as seen in FIG. 13, although the characteristic peaks of Cs2PtI6 are present as a competing byproduct. The same result occurs if the halide is substituted with bromide or chloride. The distinctive crystal morphology of cubes of Cs4Au1.33Pt1.67□I12 is shown in FIG.14. The SEM images of (a) Cs4Au1.33Pt1.67I12 are presented in FIG. 14. The perovskite of FASnI3 is also presented forming a Catalan solid (rhombic dodecahedron). Optically, the band gap of the compounds was measured using UV-vis-NIR spectroscopy and is measured to be approximately 1eV.

The compound Cs4Au1.33Pt1.67□I12 may be synthesized by a stoichiometric reaction of PtCl2 and Au in aqueous hydroiodic acid followed by precipitation of the product upon addition of Cs2CO3. In the reaction AuIII gets reduced by PtII, with the latter oxidizing to PtIV.

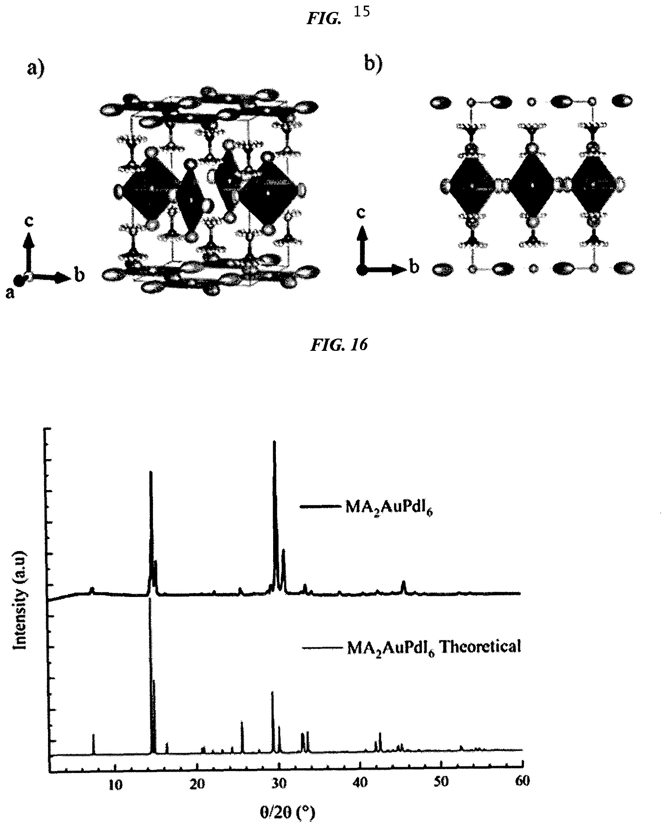

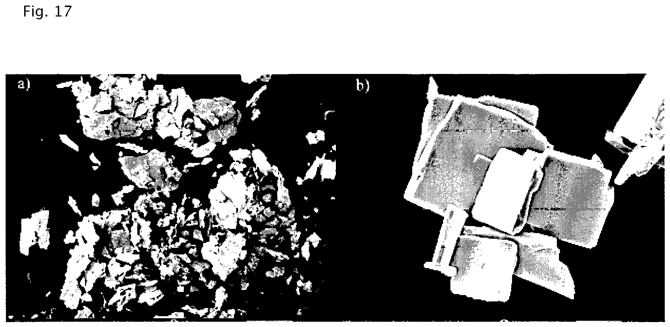

In a furthermore embodiment of the invention, the pattern of MA2AuPdI6 of formula A2MM'X6 structure wherein MA is methylammonium, being an organic monovalent cation, crystalizes according to FIG. 15, in the tetragonal P4/mbm space group. The crystal structure consists of [AuI4]- and [PdX4]2- squares, with the preferred oxidation states being AuIII and PdII based on coordination considerations. The structure comprises of two discrete metal sites both of which occupy a separate layer interchangeably along the tetragonal crystallographic axis. The layer assigned to Au exhibits an analogous rotation to that of Cs analogue, flipping 90 degrees about the 4-fold symmetry axis lying flat on the ac- and bc-planes. The layers attributed to Pd on the other hand, sitting bilaterally to the gold layers, have the plane lying parallel to the ab-plane and exhibit no rotation. These layers exhibit a large degree of disorder, which is especially evident on the large thermal ellipsoids on the corner-connected iodides. This is a unique connectivity for Pd (PdI2 is sharing edges, not corners). The comparison of the theoretical and experimental XRD pattern of MA2AuPd0.5I6 shows compliance FIG.16. SEM images of MA2AuPd0.5I6 are shown in FIG.17, wherein a further magnification is shown.

A particularly suitable method for the determination of the structure is X-ray diffraction. A nonlimiting method for Single Crystal XRD diffraction was used in this invention comprising a full-sphere data were collected using ω and φ scans using Bruker D8 Venture single-crystal diffractometer equipped with a IµS 3.0 Mo source (λ = 0.71073 Å) and Photon II 2D detector. The collected data were integrated and corrected using the CrysAlis Pro software by Rigaku. Crystal structures were solved by direct methods and refined using the JANA2006 software. Furthermore, powder X-Ray Diffraction measurements were performed on a Rigaku SmartLab SE system equipped with a equipped with a Cu Kα source (λ = 1.5406 Å) operating at 50mA and 40kV and a D/teX Ultra 250 1D silicon strip detector. Data were collected in Bragg-Brentano (reflection mode) in the 20 = 2-60∘ range.

In addition, powder X-Ray Diffraction measurements were performed on a Rigaku SmartLab SE system equipped with a Cu Kα source (λ = 1.5406 Å) operating at 50mA and 40kV and a D/teX Ultra 250 1D silicon strip detector. Data were collected in Bragg-Brentano (reflection mode) in the 20 = 2-60∘ range.

Optical diffuse reflectance measurements were performed using a Shimadzu 2600 Plus UVVIS-NIR spectrometer equipped with an ISR 2600Plus integrating sphere and operating in the 185-1400 nm spectral range. BaSO4 was used as the 100% reflectance reference in the throughout the measuring range. The band gap of the material was estimated by converting reflectance to absorption according to the well-known Kubelka-Munk equation.

### EXAMPLES

Methods are provided herein for making metal halide perovskites compounds of the invention. The methods may be used to produce bulk and/or microsize crystals of the metal halide perovskites. The metal halide perovskites compounds of the invention and their method of preparing as described herein may be illustrated by the following examples which are not to be construed as limiting the scope of the invention.

### General Method

A method for preparing a halide perovskite crystalline compound of the invention, comprising:
i) adding elemental M' or a compound comprising a transition metal M', wherein M' is selected from Ni, Pd, Pt and combinations thereof, to elemental M or a compound comprising transition metal M, wherein M selected from Cu, Ag, Au and combinations thereof, into concentrated a hydrohalic acid (HX), wherein X is a halide selected from Cl, Br and I,
ii) heating the mixture of step i) to boil until clear solution is obtained,
iii) adding a monovalent cation A salt, wherein A is selected from Li, Na, K, Rb, Cs or an organic monovalent cation and combinations thereof,
iv) cooling to ambient temperature at about 25°C.

### EXAMPLE 1

### Synthesis of the formula A5MM'2X10 one-dimensional (1D) Perovskite chains structure of the invention

### EXAMPLE 1a. Preparation of Cs5CuPd2Cl10

Solid CuCl (0.2 mmol, 20 mgr) and α-PdCl2 (0.2 mmol, 35 mg) were added a 20 mL scintillation vial followed by the addition of concentrated aqueous hydrochloric acid (37 % w/w, 10ml). The mixture was then transferred to a hotplate, covered with a glass microscope slide and heated under mild stirring to boil until reflux conditions. After 15 min, solid CsCl (0.5 mmol, 84 mg) is dissolved to the solution, with no observable color change. After 5 min of further stirring, the stirring was discontinued, and the solution was left to naturally cool to ambient temperature. Formation of needle-shaped brown crystals was observed after 60 min accompanied by the discoloration of the solution to a yellow color.

The crystals were isolated with suction filtration, washed copiously with water and dried for a further 30 min under vacuum. Yield: 160mg (80%) based on total Pd content.

### EXAMPLE 1b. Preparation of CsSAgPd2Br10

Using the same process Cs5AgPd2Br10 was synthesized using a 1:2 ratio of AgBr (0.1 mmol, 19 mg) and α-PdCl2 (0.2 mmol, 35 mg) and CsBr (0.5 mmol, 100 mg) in aqueous hydrobromic acid (47 % w/w 5ml). Yield: 100 mg (60%) based on total Ag content.

### EXAMPLE 1c. Preparation of Cs5CuPd2Br10

Using the same process small amounts of CsSCuPd2Br10 using a 1:1 amount of CuCl and PdCl2 with the main products being competing products of Palladium. Notably Cs2PdBr4 and Cs2PdBr6.

Crystallographic information and bonding parameters are given in Table 1.

**Table 1. Crystal data and structure refinement for Cs5M'Pd2X10 crystals at 293 K**

| | | | |
|---|---|---|---|
| Empirical formula | Cs5Cu1Pd2Cl10 | Cs5Cu1Pd2Br10 | Cs5Ag1Pd2Br10 |
| Formula weight | 1295.4 | 1739.9 | 1784.2 |
| Temperature | 293 K | 293 K | 293 K |
| Wavelength | 0.71073 Å | 0.71073 Å | 0.71073 Å |
| Crystal system | orthorhombic | orthorhombic | orthorhombic |
| Space group | Pbam | Pbam | Pbam |

| Unit cell dimensions | a = 16.8538(11) Å, α = 90° | a = 17.5157(8) Å, α = 90° | a = 18.0220(8) Å, α = 90° |
|---|---|---|---|
| | b = 8.8216(8) Å, β = 90° | b = 9.1626(6) Å, β = 90° | b = 9.2326(7) Å, β = 90° |
| | c = 7.7592(6) Å, γ = 90° | c = 8.0969(6) Å, γ = 90° | c = 8.0767(5) Å, γ = 90° |
| Volume | 1153.62(16) Å3 | 1299.47(14) Å3 | 1343.88(14) Å3 |
| Z | 2 | 2 | 2 |
| Density (calculated) | 3.7293 g/cm3 | 4.4467 g/cm3 | 4.4093 g/cm3 |
| Absorption coefficient | 11.369 mm-1 | 24.441 mm-1 | 23.571 mm-1 |
| F(000) | 1132 | 1492 | 1528 |
| θ range for data collection | 2.42 to 41.9° | 2.33 to 42.05° | 2.26 to 41.86° |
| Index ranges | -26<=h<=31, | -28<=h<=28, | -29<=h<=28, |
| | -13<=k<=16, | -14<=k<=14, | -14<=k<=16, |
| | -13<=1<=12 | -14<=1<=13 | -13<=1<=13 |
| Reflections collected | 76986 | 94185 | 98089 |
| Independent reflections | 3723 [Rint = 0.1079] | 1269 [Rint = 0.099] | 1316 [Rint = 0.1006] |
| Completeness to θ = 36.74° | 98.00% | 98.00% | 98.00% |
| Refinement method | Full-matrix least-squares on F2 | Full-matrix least-squares on F2 | Full-matrix least-squares on F2 |
| Data / restraints / parameters | 3723/0/51 | 1269/0/51 | 1316/ 0/51 |
| Goodness-of-fit | 1.09 | 1.34 | 1.3 |
| Final R indices [I>2σ(I)] | Robs = 0.0405, wRobs = 0.0652 | Robs = 0.0202, wRobs = 0.0494 | Robs = 0.0210, wRobs = 0.0501 |
| R indices [all data] | Rail = 0.1683, wRall = 0.0834 | Rail = 0.0230, wRall = 0.0502 | Rail = 0.0243, wRall = 0.0509 |
| R = ∑∥Fo\|-\|Fc∥ / ∑\|Fo\|, wR = {∑[w(\|Fo\|2 - \|Fc\|2)2] / ∑[w(\|Fo\|4)]} 1/2 and w=1/(σ2(I)+0.0004I2) | | | |

### EXAMPLE 2

### Synthesis of the formula A2MM'X5 Vacant anion double Perovskite structure of the invention

### 2a. Preparation of Cs2AgPdCl5

Solid Ag2CO3 (0.1 mmol, 28 mg) and α-PdCl2 (0.2 mmol, 36 mg) were added in a 20 mL scintillation vial followed by the addition of concentrated aqueous hydrochloric acid (37 % w/w, 10ml). The mixture was then transferred to a hotplate, covered with a glass microscope slide and heated under mild stirring to boil until reflux conditions. After about 15 min, solid CsCl (0.5 mmol, 84 mg) is added to the solution, without observable color change. After 5 min of further stirring, the stirring was discontinued, and the solution was left to cool to ambient temperature. Formation of brown crystals was observed after 60 min accompanied by the discoloration of the solution to a yellow color. The crystals were isolated with suction filtration and dried for a further 30 min under vacuum. Yield: 92mg, (70%) based on total Ag content.

Crystallographic information and bonding parameters are given in Table 2.

**Table 2. Crystal data and structure refinement for Cs₂AgPdCl₅ crystals at 293 K**

| | |
|---|---|
| Empirical formula | **Cs2 Ag1 Pd1 Cl5** |
| Formula weight | 524.4 |
| Temperature | 293 K |
| Wavelength | 0.71073 Å |
| Crystal system | tetragonal |
| Space group | P 4/m m m |
| Unit cell dimensions | a = 7.4297(7) Å, α = 90.000° |
| | b = 7.4297(7) Å, β = 90.000° |
| | c = 4.9183(5) Å, γ = 90.000° |
| Volume | 271.49(5) Å3 |
| Z | 1 |
| Density (calculated) | 3.2077 g/cm3 |
| Absorption coefficient | 7.916 mm-1 |
| F(000) | 288 |
| θ range for data collection | 2.74 to 46.44° |
| Index ranges | -14<=h<=15, -15<=k<=15, - 9<=1<=10 |
| Reflections collected | 31442 |
| Independent reflections | 176 [Rint = 0.1512] |
| Completeness to θ = 46.44° | 98.00% |
| Refinement method | Full-matrix least-squares on F2 |
| Data / restraints / parameters | 176/0/14 |
| Goodness-of-fit | 4.81 |
| Final R indices [I>2σ(I)] | Robs = 0.0610, wRobs = 0.1715 |
| R indices [all data] | Rail = 0.0719, wRall = 0.1717 |
| R = ∑∥Fo\|-\|Fc∥ / ∑\|Fo\|, wR = {∑[w(\|Fo\|2 - \|Fc\|2)2] / ∑[w(\|Fo\|4)]} 1/2 and w=1/(σ2(I)+0.0004I2) | |

### EXAMPLE 3

### Synthesis of the formula A4M2M'X12 Vacancy-ordered Perovskite structure of the invention

### 3a. Preparation of Cs4Au2Pd_{□}Cl12

Solid AuCl3·xH2O (0.1mmol, 39 mg) and α-PdCl2 (0.1 mmol, 18 mg) were added a 20 mL scintillation vial followed by the addition of concentrated aqueous hydrochloric acid (37 % w/w, 5ml). The heterogeneous mixture was then transferred to a hotplate, covered with a glass microscope slide and heated under mild stirring to boiling until it reaches a thermodynamic equilibrium under reflux conditions. After 15 min, solid CsCl (0.2 mmol, 36 mg) is added to the solution, dissolving immediately and producing no observable color change. Stirring was immediately, and the solution was left to naturally cool to ambient temperature at about 25°C. Formation of small grain like black crystals was observed after 5 min. After 60 min discoloration of the solution was observed to a yellow color. The crystals were isolated with suction filtration, washed copiously with water and dried for a further 30 min under vacuum.

Yield: 120 mg, (80%) based on total Pd content. Similar results were achieved with the use of 0.1mmol of Pd(OAc)2 in place of PdCl2.

### 3b. Preparation of Cs4Au2Pd□Br12

Elemental Au (0.1mmol, 39mg) is added a 20 mL scintillation vial followed by the addition of concentrated aqueous hydrobromic acid (47 % w/w 5ml) and hydroiodic acid, approximately 0.1mol of liquid Br2 is added and the heterogeneous mixture was then transferred to a hotplate, covered with a glass microscope slide and heated under mild stirring to boiling until it reaches a thermodynamic equilibrium under reflux conditions. If the elemental Au has dissolved in the acid Pd(OAc)2 (0.1mmol, 23mg) is added, this turns the mixture to dark brown, if Au is still present more Br2 is added in the mixture and left to stir until gold is dissolved. Solid CsCl (0.2 mmol, 36 mg) is added to the solution, dissolving immediately and producing no observable color change. Stirring was halted, and the solution was left to naturally cool to ambient temperature at about 25°C. Formation of small grain like black crystals was observed after 5 min. After 60 min discoloration of the solution was observed to a yellow color. The crystals were isolated with suction filtration, washed copiously with water and dried for a further 30 min under vacuum.

Yield: 160 mg (80%) based on total Pd content. Similar results were achieved with the use of 0.1mmol of α-PdCl2 replacing Pd(OAc)2.

### 3c. Preparation of Cs4Au2Pd□I12

Using the same process Cs4Au2PdoI12 was synthesized using a 1:1 ratio of elemental Au (0.1 mmol, 20 mg) and Pd(OAc)2 (0.1mmol, 23mg) and Cs2CO3 in aqueous hydroiodic acid (48 % w/w 5ml).

Yield: 200 mg (80%) based on total Pd content.

### 3d. Preparation of Rb4Au2Pd□I12

Using the same process Cs4Au2PdoI12 was synthesized using a 1:1 ratio of elemental Au (0.1 mmol, 20 mg) and Pd(OAc)2 (0.1mmol, 23mg) and RbCl (0.5mmol, 60mg) in aqueous hydroiodic acid (48 % w/w 5ml).

Yield: 180 mg (80%) based on total Pd content.

Crystallographic information and bonding parameters are summarized in Table 3.

**Table 3 Crystal data and structure refinement for A4M2M'X12crystals at 293 K**

| Empirical formula | Au1.979 Cl12 Cs4 Pd1.021 | Cs4 Au1.846 Pd1.154 Br12 | Au1.388 Cs4 I12 Pd1.612 |
|---|---|---|---|
| Formula weight | 1455.5 | 1976.9 | 2499.4 |
| Temperature | 293 K | 293 K | 293 K |
| Wavelength | 0.71073 Å | 0.71073 Å | 0.71073 Å |
| Crystal system | cubic | cubic | cubic |
| Space group | I a -3 d | I a -3 d | Ia-3d |
| Unit cell dimensions | a = 20.9712(11) Å, | a = 21.826(2) Å, | a = 23.2003(3) Å, |
| | α = 90° | α = 90° | α =90° |
| | b = 20.9712(11) Å, | b = 21.826(2) Å, | b = 23.2003(3) Å, |
| | | β = 90° | β = 90° |
| | β = 90° | c = 21.826(2) Å, | c = 23.2003(3) Å, |
| | c = 20.9712(11) Å, | γ = 90° | γ = 90° |
| | γ = 90° | | |
| Volume | 9223.0(8) Å3 | 10397.8(17) Å3 | 12487.7(3) Å3 |
| Z | 16 | 16 | 16 |
| Density (calculated) | 4.1928 g/cm3 | 5.0513 g/cm3 | 5.3177 g/cm3 |
| Absorption coefficient | 20.946 mm-1 | 35.135 mm-1 | 23.879 mm-1 |
| F(000) | 10037 | 13423 | 16637 |
| θ range for data collection | 2.38 to 41.65° | 2.29 to 41.59° | 2.15 to 36.92° |
| Index ranges | -33<=h<=38, - 33<=k<=36, - 38<=1<=32 | -35<=h<=35, - 36<=k<=35, - 40<=1<=32 | -36<=h<=38, - 33<=k<=37, - 37<=1<=36 |
| Reflections collected | 353643 | 412885 | 531021 |
| Independent reflections | 702 [Rint = 0.2495] | 789 [Rint = 0.6571] | 946 [Rint = 0.193] |
| Completeness to θ = 41.65° | 98.00% | 98.00% | 98.00% |
| Refinement method | Full-matrix least-squares on F2 | Full-matrix least-squares on F2 | Full-matrix least-squares on F2 |
| Data / restraints / parameters | 702 / 0 / 32 | 789 / 0 / 32 | 946 / 0 / 32 |
| Goodness-of-fit | 3.38 | 1.64 | 5.56 |
| Final R indices [I>2σ(I)] | Robs = 0.0616, | Robs = 0.0816, | Robs = 0.1040, |
| | wRobs = 0.1520 | wRobs = 0.0926 | wRobs = 0.2170 |
| R indices [all data] | Rail = 0.0763, | Rall = 0.1200, | Rall = 0.1063, |
| | wRall = 0.1536 | wRall = 0.0998 | wRall = 0.2174 |
| R = ∑∥Fo\|-\|Fc∥ / ∑\|Fo\|, wR = {∑[w(\|Fo\|2 - \|Fc\|2)2] / ∑[w(\|Fo\|4)]}1/2 and w=1/(σ2(I)+0.0004I2) | | | |

### EXAMPLE 4

### Preparation of Cs4Au1.33Pt1.67I12

A 1:1 ratio of elemental Au and solid PtCl2 (0.1 mmol, 27 mg) and Cs2CO3 (2.5 mmol, 82 mg) in aqueous hydroiodic acic (48 % w/w 5ml). Yield: 100mg (40%) based on total Au content.

Crystallographic information and bonding parameters are given in Table 4.

**Table 4 Crystal data and structure refinement for A4M1.33M'1.67X12 crystals at 293 K**

| Empirical formula | Au1.33 Cs4 I12 Pt1.67 |
|---|---|
| Formula weight | 2642.6 |
| Temperature | 293 K |
| Wavelength | 0.71073 Å |
| Crystal system | cubic |
| Space group | *P m -3 m* |
| Unit cell dimensions | a = 11.7445(4) Å, α = 90.000(3)° |
| | b = 11.7445(4) Å, β = 90.000(3)° |
| | c = 11.7445(5) Å, γ = 90.000(3)° |
| Volume | 1619.96(10) Å3 |
| Z | 1 |
| Density (calculated) | 2.7087 g/cm3 |
| Absorption coefficient | 14.545 mm-1 |
| F(000) | 2183 |
| θ range for data collection | 1.73 to 35.54° |
| Index ranges | -18<=h<=18, -19<=k<=17, - 19<=1<=18 |
| Reflections collected | 161274 |
| Independent reflections | 349 [Rint = 0.1474] |
| Completeness to θ = 35.54° | 99.00% |
| Refinement method | Full-matrix least-squares on F2 |
| Data / restraints / parameters | 349 / 0 / 18 |
| Goodness-of-fit | 6.77 |
| Final R indices [I>2σ(I)] | Robs = 0.0793, wRobs = 0.2306 |
| R indices [all data] | Rail = 0.0804, wRall = 0.2307 |
| R = ∑∥Fo\|-\|Fc∥ / ∑\|Fo\|, wR = {∑[w(\|Fo\|2 - \|Fc\|2)2] / ∑[w(\|Fo\|4)]} 1/2 and w=1/(σ2(F)+0.0001F2) | |

### EXAMPLE 5

### Synthesis of formula structure A2MM'0.5X6 of the invention

### 5a. Preparation of (CH3NH3)2AuPd0.5I6

A 1:1 ratio of elemental Au and Pd(OAc)2 and MACl in aqueous hydroiodic acic (48 % w/w 5ml). The final product compromises of small tertragonal jet black crystals. Yield: 180 mg (80%) based on total Pd content.

Crystallographic information and bonding parameters are given in Table 5.

**Table 5 Crystal data and structure refinement for (CH3NH3)2AuPd0.5I6 crystals at 293 K.**

| Empirical formula | C2 H12 Au1 I6 N2 Pd0.5 |
|---|---|
| Formula weight | 1128.9 |
| Temperature | 293 K |
| Wavelength | 0.71073 Å |
| Crystal system | tetragonal |
| Space group | P 4/m b m |
| Unit cell dimensions | a = 8.6043(8) Å, α = 90° |
| | b = 8.6043(8) Å, β = 90° |
| | c = 11.8798(14) Å, γ = 90° |
| Volume | 879.51(16) Å3 |
| Z | 2 |
| Density (calculated) | 4.2629 g/cm3 |
| Absorption coefficient | 19.854 mm-1 |
| F(000) | 962 |
| θ range for data collection | 1.71 to 40.98° |
| Index ranges | -15<=h<=13, -13<=k<=15, - 21<=l<=19 |
| Reflections collected | 60720 |
| Independent reflections | 470 [Rint = 0.211] |
| Completeness to θ = 40.32° | 98.00% |
| Refinement method | Full-matrix least-squares on F2 |
| Data / restraints / parameters | 470 / 1 / 22 |
| Goodness-of-fit | 4.29 |
| Final R indices [I>2σ(I)] | Robs = 0.0820, wRobs = 0.1956 |
| R indices [all data] | Rail = 0.1055, wRall = 0.2004 |
| R = ∑∥Fo\|-\|Fc∥ / ∑\|Fo\|, wR = {∑[w(\|Fo\|2 - \|Fc\|2)2] / ∑[w(\|Fo\|4)]} 1/2 and w=1/(σ2(I)+0.0004I2) | |

A summary of the crystal structures and the physical properties of the compounds prepared in Examples 1-5 is presented in Table 6. It is evident that the new halide perovskite crystalline compounds disclosed in this invention exhibit exciting physical properties such as medium gap bandgaps in the range of 0.8-2.0 eV. A major advantage of these materials over the regular lead-based perovskites is their excellent stability against water which in combination with their suitable bandgaps makes them suitable for use in optoelectronic devices. Of particular interest in photovoltaics is the compound (CH3NH3)2AuPd0.5I6 as an active layer in solar cells due to its 1.1 eV direct bandgap and increased stability.

**Table 6. Physical properties of the compounds prepared in Examples 1-5.**

| Formula | Color | Space group | Band gap (eV) | Decomposition T (°C) | Water stability |
|---|---|---|---|---|---|
| Cs5CuPd2Cl10 | Brown | Pbam | 2.1 | 600 | good |
| Cs5AgPd2Br10 | Black/Dark Brown | Pbam | 1.9 | 500 | good |
| Cs2AgPdCl5 | Brown | P4/mmm | 1.5 | - | poor |
| Cs4Au2Pd□Cl12 | Black | Ia-3d | 1.6 | 400 | waterproof |
| Cs4Au2Pd□Br12 | Black | Ia-3d | 1.3 | 350 | waterproof |
| Cs4Au2Pd□I12 | Black | Ia-3d | 0.8 | 250 | waterproof |
| Rb4Au2Pd□I12 | Black | Ia-3d | 0.9 | 200 | waterproof |
| Cs4Au1.33Pt1.67□I12 | Black | Pm-3m | 1.1 | - | waterproof |
| MA2AuPd0.5I6 | Metalic Black | P4/mbm | 1.1 (direct) | 150 | good |

## Claims

1. A halide perovskite crystalline compound of the general formula AaMbM'cXd and mixtures thereof, containing of:
i) a monovalent cation A selected from Li, Na, K, Rb, Cs or an organic monovalent cation and combinations thereof,
ii) a halogen X selected from F, Cl, Br, I and combinations thereof,
iii) at least one transition metal M selected from Cu, Ag, Au and combinations thereof, and
iv) a second transition metal M' selected from Ni, Pd, Pt and combinations thereof,
wherein a and d, are integer numbers and the molecular ratio b:c of two transition metals is 1:2 to 2:1.

2. A halide perovskite crystalline compound according to claim 1, wherein the organic monovalent cation is selected from methylammonium (CH3NH3+) and formamidinium (HC(NH2)2.

3. A halide perovskite crystalline compound according to claims 1 to 2, wherein the molecular ratio of the halogen to monovalent cation d:a is within the range of 3.0 -1.0.

4. A halide double perovskite crystalline compound according to claims 1 to 3, wherein when a=2 then d=5 or 6, when a=4 then d=12 and when a=5 then d=10.

5. A halide perovskite crystalline compound according to claim 1, wherein each compound of the general formula AaMbM'cXd thereof is selected from the group consisting of: A2MbM'cX5, A2MbM'cX6, A4MbM'cX12, A4MbM'cX12, A5MbM'cX10.

6. A halide perovskite crystalline compound according to proceeding claims, wherein b and c are selected from the range 0.1-3.0.

7. A halide perovskite crystalline compound according to claim 6, wherein each compound is selected from the group consisting of Cs2AgPdCl5, (CH3NH3)2AuPd0.5I6, Cs4Au2PdCl12, Cs4Au2PdBr12, Cs4Au2PdI12, Rb4Au2PdI12, Cs4Au1.33Pt1.67I12, Cs5CuPd2Cl10, Cs5AgPd2Br10 and Cs5CuPd2Br10.

8. A halide double perovskite crystalline compound according to proceeding claims, in the form of powder, single crystal or thin film.

9. A method for preparing a halide perovskite crystalline compound according to proceeding claims, comprising:
i) adding elemental M or a compound comprising a transition metal M, wherein M is selected from Cu, Ag, Au and combinations thereof, to elemental M' or a compound comprising transition metal M', wherein M' selected from Ni, Pd, Pt and combinations thereof, into a hydrohalic acid (HX), wherein X is a halide selected from Cl, Br and I,
ii) heating the mixture of step i) to boil until a solution is obtained,
iii) adding a monovalent cation A salt, wherein A is selected from Li, Na, K, Rb, Cs or an organic monovalent cation and combinations thereof,
iv) cooling.

10. A method for preparing a halide perovskite crystalline compound according to claim 9, wherein the mixture of step i) is covered with a surface.

11. A method for preparing a halide perovskite crystalline compound according to claims 9 to 11, wherein the hydrohalic acid (HX) in step i) is in concentrated grade.

12. A method for preparing a halide perovskite crystalline compound according to claim 9, wherein cooling at ambient temperature is at about 25°C.

13. Use of a halide perovskite crystalline compound according to proceeding claims for the manufacturing of solar cells by deposition on a substrate or single crystal growing.

14. Use of a halide perovskite crystalline compound according to proceeding claims for the manufacturing of an electrical communicator between electrodes in an optoelectronic device, by layering.
